# EUROPEAN PATENT SPECIFICATION

(11) **EP 3 208 445 B1**
(45) Date of publication and mention of the grant of the patent: **17.04.2019**
(21) Application number: 17156615.1
(22) Date of filing: 17.02.2017
(51) Int. Cl.: F02C 7/143, H01L 35/28, F02C 7/18

(54) **GAS TURBINE ENGINE WITH THERMOELECTRIC COOLING AIR HEAT EXCHANGER**
GASTURBINENMOTOR MIT THERMOELEKTRISCHEM KÜHLLUFTWÄRMETAUSCHER
MOTEUR À TURBINE À GAZ AVEC ÉCHANGEUR DE CHALEUR D'AIR DE REFROIDISSEMENT THERMOÉLECTRIQUE

(30) Priority: 18.02.2016 US 201662296846 P; 26.02.2016 US 201662300460 P
(43) Date of publication of application: 23.08.2017
(73) Proprietor: Rolls-Royce North American Technologies, Inc., Indianapolis, IN 46241 (US)
(72) Inventor: Dierksmeier, Douglas, Franklin, IN Indiana 46131 (US); Karam, Michael, Plainfield, IN Indiana 46168 (US); Vetters, Daniel, Indianapolis, IN Indiana 46234 (US)
(74) Representative: Rolls-Royce plc

(56) References cited:
- EP-A2- 2 581 554
- JP-A- 2008 232 086
- US-A1- 2013 213 054
- US-A1- 2015 372 214

## Description

The present disclosure relates generally to gas turbine engines, and more specifically to the interaction of sub-systems used in gas turbine engines.

Gas turbine engines are used to power aircraft, watercraft, power generators, and the like. Gas turbine engines typically include a compressor, a combustor, and a turbine. The compressor compresses air drawn into the engine and delivers high pressure air to the combustor. In the combustor, fuel is mixed with the high pressure air and is ignited. Exhaust products of the combustion reaction in the combustor are directed into the turbine where work is extracted to drive the compressor and, sometimes, an output shaft, fan, or propeller.

Cooling air is often routed to various portion of gas turbine engines to remove heat therefrom. Cooling air may be cooled by a heat exchanger before being distributed to those portions of the gas turbine engine.

European patent application EP 2581554 A2 discloses a gas turbine engine with a cooling system that includes a solid-state thermoelectric heat exchanger. The heat exchanger is coupled between first and second fluid pathways and is electrically activated to transfer heat from the first fluid pathway to the second fluid pathway.

United States patent application US 2015/372214 A1 discloses a gas turbine engine with a cooling system that includes a thermoelectric heat exchanger. A cooling fluid is passed through the heat exchanger and a cold fluid is passed through the heat exchanger to cool the cooling fluid.

The present disclosure may comprise one or more of the following features and combinations thereof.

According to an aspect of the present disclosure, there is provided a gas turbine engine comprising a cooling air system adapted to provide cooling air to portions of the gas turbine engine, a coolant system adapted to provide coolant for heat exchange with the cooling air system of the gas turbine engine, and a thermoelectric heat exchanger including a cooling air passageway fluidly coupled to the cooling air system to conduct cooling air of the cooling air system therethrough, a coolant passageway fluidly coupled to the cooling system to conduct coolant of the coolant system therethrough, and a thermoelectric section configured in thermal communication with each of the cooling air passageway and the coolant passageway, characterised in that it further comprises a controller configured to determine an operational state of the gas turbine engine and to selectively apply voltage across the thermoelectric section based on the operational state of the gas turbine engine.

In some embodiments, the coolant system may include one of a coolant air system having air as the coolant and a fuel system having fuel as the coolant.

In some embodiments, gas turbine engine may be configured to provide propulsion for an aircraft and the operational state of the gas turbine engine includes one of ground idle, takeoff, climb, cruise, and flight idle.

In some embodiments, the controller may be configured to extract electric power from the thermoelectric section in response to determination that the operational state of the gas turbine engine is cruise.

In some embodiments, the controller may be configured to apply voltage across the thermoelectric section to direct current through the thermoelectric section in a first direction in response to determination that the operational state of the gas turbine engine is one of takeoff and climb to encourage heat transfer through the thermoelectric section from the cooling air passageway to the coolant passageway.

In some embodiments, the thermoelectric controller may be configured to apply voltage across the thermoelectric section to direct current through the thermoelectric section in a second direction in response to determination that the operational state of the gas turbine engine is flight idle.

In some embodiments, the thermoelectric section may include a number of electrically connected thermoelectric layers and the cooling air passageway includes a number of cooling air conduits each having at least one wall in thermal communication with at least one of the thermoelectric layers.

In some embodiments, at least one of the number of cooling air conduits may have a circumferential width that is tapered along a radial direction.

In some embodiments, the thermoelectric section may include a number of electrically connected thermoelectric layers and the coolant passageway may include a number of coolant conduits each having at least one wall in thermal communication with at least one of the thermoelectric layers and each of the coolant conduits defines a coolant flow path that extends radially in communication with a turnaround passage of the coolant passageway.

In some embodiments, the gas turbine engine may comprise a compressor configured to pressurized air, a combustor configured to receive pressurized air from the compressor and fuel for combustion to yield combustion products, a turbine is configured to receive and expand combustion products from the combustor to drive rotation around a central axis, and wherein the cooling air passageway is fluidly coupled to the compressor to receive pressurized air through the cooling air passageway.

In some embodiments, the controller may be configured to selectively provide electric power generated by the thermoelectric section to a load of the gas turbine engine.

In some embodiments, the thermoelectric heat exchanger may be configured to provide no electric power to the thermoelectric section in response to determination that the operational state of the gas turbine engine is ground idle.

According to another aspect of the present disclosure, there is provided a method of operating a gas turbine engine of the aforementioned aspect for providing propulsion for an aircraft, the method comprising determining an operational state of the gas turbine engine; based on the determined operational state, determining whether excess thermal differential exists between a cooling air system and a coolant system of the gas turbine engine; based on the determined operational state, selectively: applying voltage across a thermoelectric section of a thermoelectric heat exchanger of the gas turbine engine in response to determination that excess thermal differential does not exist, or extracting electric power from the thermoelectric section of the thermoelectric heat exchanger in response to determination that excess thermal differential does exist.

In some embodiments, selectively applying voltage across the thermoelectric section of the thermoelectric heat exchanger may include, in response to determination that an excess thermal differential does not exist based on the determined operational state, selectively directing current through the thermoelectric section in a first direction to encourage heat transfer through the thermoelectric section from the cooling air system to the coolant system based on the determined operational state.

In some embodiments, selectively applying voltage across the thermoelectric section of the thermoelectric heat exchanger may include, in response to determination that an excess thermal differential does not exist based on the determined operational state, selectively directing current through the thermoelectric section in a second direction.

These and other features of the present disclosure will become more apparent from the following description of the illustrative embodiments.

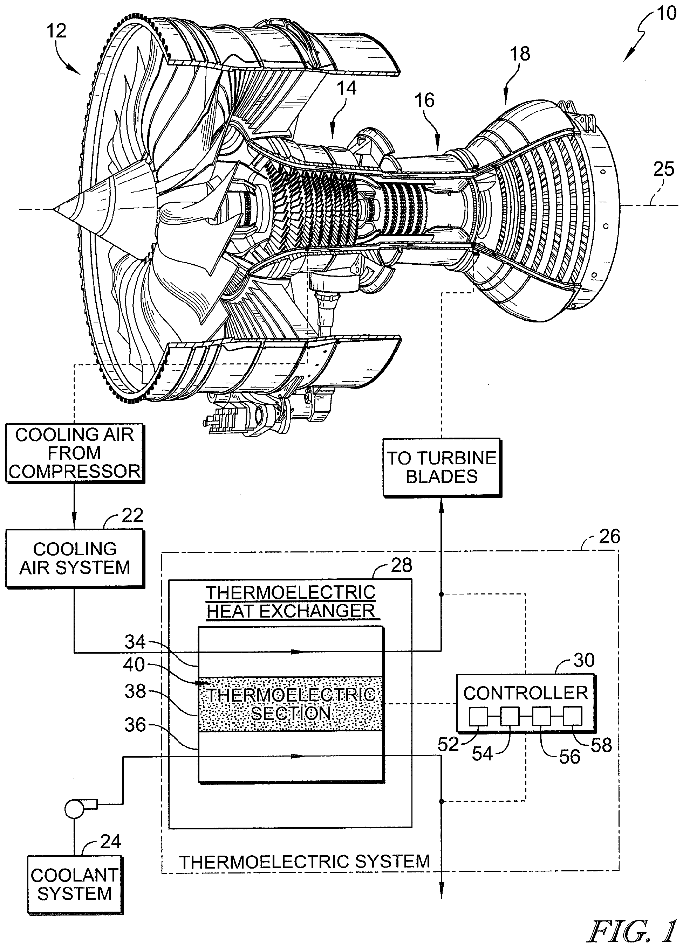

Fig. 1 is a partially diagrammatic gas turbine engine diagrammatically showing that the gas turbine engine includes a turbine engine cooling air system, a coolant system, and a thermoelectric system for controlling heat exchange between air from the cooling air system and coolant from the coolant system provided by a thermoelectric heat exchanger and a turbine engine controller in communication with various sensors, and showing that the thermoelectric heat exchanger has a cooling air passageway, a coolant passageway, and a thermoelectric section disposed between and in thermal communication with each of the cooling air passageway and the coolant passageway;

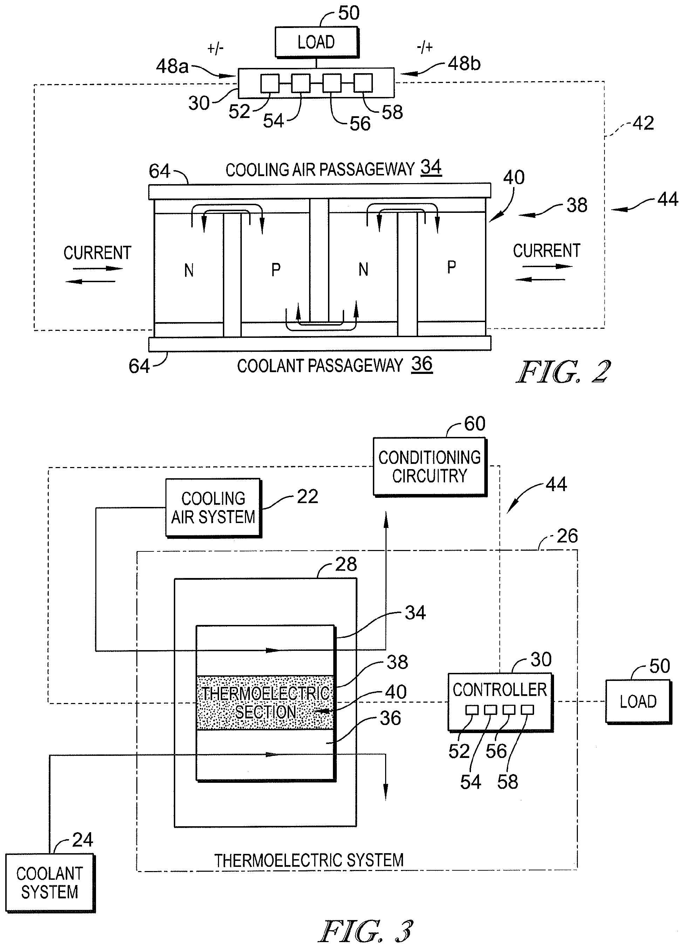

Fig. 2 is a diagrammatic view of an illustrative embodiment of the thermoelectric system of the gas turbine engine of Fig. 1 showing that thermoelectric section includes a circuit of semiconductor materials including positively charged (P-type) and negatively charged (N-type) thermoelectric materials arranged in alternating series to provide a thermoelectric circuit for receiving current therethrough in a first direction (counter-clockwise) encouraging transfer of heat through the thermoelectric section from the lubrication passageway to the fuel passageway, and in a second direction (clockwise) discouraging transfer of heat through the thermoelectric section from the lubrication passageway to the fuel passageway;
Fig. 3 is a diagrammatic view of the thermoelectric system included in the gas turbine engine of Fig. 1 showing that the turbine engine controller of the thermoelectric system includes circuitry for determining an operational state of the gas turbine engine and for selectively operating to supply electric power to the thermoelectric layer or to extract electric power from the thermoelectric layer based on the determined operational state;

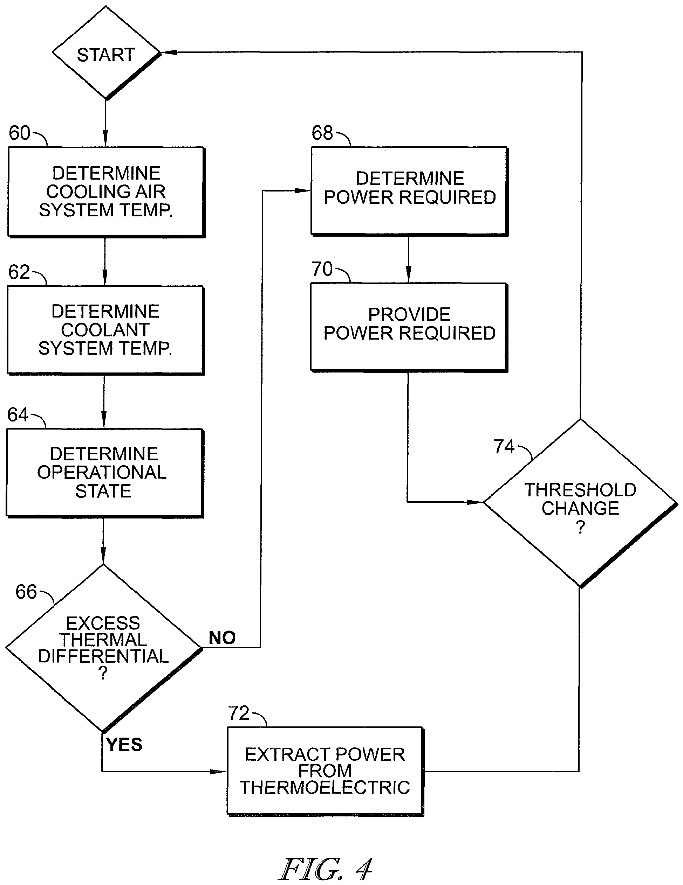

Fig. 4 is process flow diagram of a control sequence of the gas turbine engine of Fig. 1 showing that the control sequence includes determining the temperatures of the cooling air system and the coolant system, determining the operational state of the gas turbine engine, determining whether excess thermal differential exists between the cooling air system and the coolant system based on the determined operational state, and selectively extracting or providing electric power to the thermoelectric system based on the existence of excess thermal differential, and showing that providing electric power to the thermoelectric system includes determining the electric power required by the thermoelectric system and providing the electric power required; and

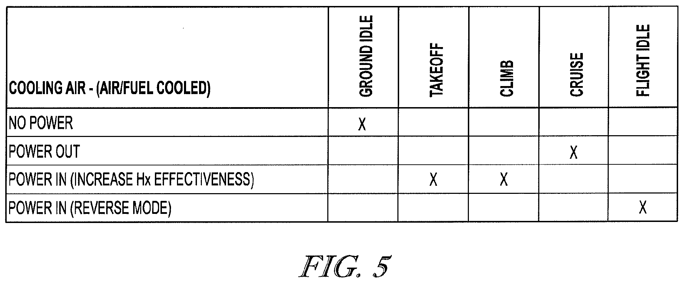

Fig. 5 is a table of exemplary operational states of the gas turbine engine of Fig. 1 adapted for use in aircraft propulsion and their general correspondence to an electrical power IN (provided) condition, an electrical power OUT (extracted) condition, and a No Power condition relative to the thermoelectric system.

For the purposes of promoting an understanding of the principles of the disclosure, reference will now be made to a number of illustrative embodiments illustrated in the drawings and specific language will be used to describe the same.

An illustrative gas turbine engine 10 includes a fan 12, a compressor 14, a combustor 16, and a turbine 18 as shown in Fig. 1. The fan 12 draws air into the compressor 14 that compresses and delivers the air to the combustor 16. The combustor 16 mixes fuel with the compressed air from the compressor 14 and combusts the mixture. The hot, high-pressure exhaust products of the combustion reaction in the combustor 16 are directed into the turbine 18 to cause turbine blades 20 to rotate about an axis 25 to drive fan 12 and compressor 14.

In the illustrative embodiment, gas turbine engine 10 includes a cooling air system 22, a coolant system 24, and a thermoelectric system 26 for governing heat exchange between systems 22, 24 as shown in Fig. 1. Cooling air system 22 illustratively provides cooling air from the compressor 14 to various portions of the gas turbine engine 10, for example, the turbine blades 20 for removing heat (cooling). Coolant system 24 illustratively provides cooling medium ("coolant") for heat exchange with the cooling air of the cooling air system 22 before the cooling air is directed to those portions of the engine 10 requiring cooling (e.g., turbine blades 20). Thermoelectric system 26 is configured to regulate heat exchange between the cooling air of the cooling air system 22 and the coolant of the coolant system 24.

In the illustrative embodiment, thermoelectric system 26 includes a thermoelectric heat exchanger 28 configured to receive cooling air and coolant therethrough in controlled thermal communication with each other, and a controller 30 configured to govern operation of thermoelectric heat exchanger 28 as shown in Fig. 1. Thermoelectric heat exchanger 28 illustratively includes a cooling air passageway 34 fluidly coupled with the cooling air system 22 to receive cooling air therefrom, a coolant passageway 36 fluidly coupled with the coolant system 24 to receive coolant therefrom, and a thermoelectric section 38 in thermal communication with each of cooling air passageway 34 and coolant passageway 36. Thermoelectric section 38 is illustratively disposed between the cooling air passageway 34 and the coolant passageway 36 as a thermal conduit through which heat can be transferred between the systems 22, 24.

As explained in detail below, thermoelectric section 38 is selectively operable to regulate the amount and direction of heat transfer therethrough as suggested in Fig. 1. For example, thermoelectric system 26 can illustratively operate to drive additional heat transfer from cooling air system 22 to coolant system 24. Driving additional heat transfer from cooling air system 22 to coolant system 24 can provide additional cooling to the cooling air system 22 during desired periods and can permit a reduction in the overall size of the heat exchanger 28 when compared with traditional exchangers without reducing the heat transfer capacity thereof.

Thermoelectric system 26 regulates heat transfer between cooling air system 22 and coolant system 24 by selective operation of thermoelectric section 38 as suggested in Fig. 1. As discussed in detail below, thermoelectric section 38 illustratively includes a thermoelectric material 40 having thermoelectric properties. In the illustrative embodiment, thermoelectric section 38 is configured such that the heat flow (rate and direction) through the thermoelectric material 40 is regulated by selectively governing the flow of electric current through thermoelectric section 34. Under certain conditions, thermoelectric section 34 can also produce electric power from an imposed thermal differential for extraction to other loads. Devices operating under similar principles are sometimes referred to Peltier and/or Seebeck devices.

Controller 30 illustratively governs operation of thermoelectric heat exchanger 28 to regulate the heat flow (rate and direction) between cooling air system 24 and coolant system 26 as suggested in Figs. 1-4. As shown in Figs. 2 and 3, controller 30 is illustratively electrically connected to thermoelectric section 38 by wiring 42 to provide a thermoelectric circuit 44. Controller 30 illustratively regulates the electric power through thermoelectric circuit 44 to govern heat transfer between systems 22, 24.

In the illustrative embodiment, controller 30 determines a desired operation of thermoelectric heat exchanger 26 based on operational scenarios and conditions of engine 10. As described in detail below, controller 30 executes the desired operation accordingly by selectively extracting electric power from, providing electric power to, or to have no power exchange with thermoelectric section 38. Having no power exchange (no power provided to or extracted from) with thermoelectric section 38 allows natural heat transfer to occur through thermoelectric heat exchanger 28. Providing power to thermoelectric section 38 can augment (increase or decrease) the natural heat transfer according to the configuration and amount of power through thermoelectric section 38. Extracting power from thermoelectric section 38 can effectively provide additional cooling to systems 22, 24 while producing useful electric power.

Controller 30 determines the desired operation of thermoelectric heat exchanger 26 based on operational scenarios and conditions of engine 10. The specific operational scenarios of gas turbine engines themselves can vary according to the adapted use of the engine 10. In the illustrative embodiment, gas turbine engine 10 is adapted for use in an aircraft and heat exchange between cooling air system 22 and coolant system 24 is described in the context of aircraft operational states including ground idle, takeoff, climb, cruise, and flight idle. In some embodiments, gas turbine engine 10 may be adapted for any known use including stationary and/or mobile electric power generation, direct and/or indirect propulsion of any manner of vehicle and/or device, and/or combinations thereof, and operational states may vary accordingly.

Controller 30 illustratively determines the operational scenarios of the engine 10 based on the operational conditions of engine 10. Controller 30 illustratively receives information from sensors 42a, 42b, 42c configured to detect and send signals indicating an operating parameter of the engine 10. Controller 30 illustratively receives the information from sensors 42a, 42b, 42c to determine the operational scenarios of the engine 10.

In the illustrative embodiment as shown in Fig. 2, thermoelectric material 40 is embodied as a number of oppositely charged (doped) semiconductor materials. Thermoelectric materials 40 illustratively include an alternating line of N-type and P-type semiconductor materials extending between cooling air passageway 34 and the coolant passageway 36 such that one end of each cooling air passageway 34 and the coolant passageway 36 is in thermal contact with one of passageways 34, 36. Adjacent pairs of N-type and P-type semiconductor materials are electrically connected to each other near to one of the cooling air passageway 34 side and the coolant passageway 36 side in alternating sequence along the flow of electric current. Thermoelectric circuit 44 is illustratively formed partially by thermoelectric material 40 to receive electric current therethrough.

Controller 30 regulates amount and direction of electric current through thermoelectric section 28 to govern heat exchange. Controller 30 regulates the direction of electric current directed through thermoelectric material 40 by selective application of the polarity of the voltage applied to thermoelectric section 38. Controller 30 selectively applies voltage to thermoelectric section 38 with particular polarity by inducing either a positive or negative pole at one terminal 48a, 48b, and the other of a positive or negative pole at the other terminal 48a, 48b. As shown in Figs. 2 and 3, controller 30 thus selectively directs current through thermoelectric section 38 in a first direction (counter-clockwise) or a second direction (clockwise).

If controller 30 determines that the desired control requires a certain amount of heat transfer between cooling air system 22 and coolant system 24, controller 30 illustratively delivers electric power through thermoelectric circuit 44 with polarity according to the desired heat flow. If instead, controller 30 determines that the desired control requires extraction of electrical power from thermoelectric section 34, controller 30 directs electric power generated by thermoelectric section 38 to a load 50 of the gas turbine engine 10. Heat within cooling air system 22 and coolant system 24 can therefore be used according to gas turbine engine 10 operation.

In the illustrative embodiment as shown in Figs. 2 and 3, current flow through thermoelectric section 38 in the first direction (counter-clockwise) causes thermoelectric material 40 to encourage heat flow from cooling air passageway 34 to coolant passageway 36. Current flow through thermoelectric section 38 in the second direction (clockwise) causes thermoelectric material 40 to discourage heat flow from cooling air passageway 34 to coolant passageway 36. Thus, by selectively applying voltage of a particular polarity (and thus current of a particular direction), controller 30 regulates the rate of heat flow through thermoelectric heat exchanger 28. In the foregoing description, the directions of electric current flow are used for non-limiting illustration purposes. In some embodiments, the absolute direction of current flow may differ from the description based on the particular geometric configuration of the thermoelectric section 34.

Returning to the illustrative embodiment as shown in Figs. 1-3, thermoelectric system 26 operates according to the operating conditions of gas turbine engine 10. When the controller 30 determines that cooling air system 22 may benefit from removal of additional heat (i.e., providing additional cooling) than is available and/or useful within the coolant system 24, the controller 30 illustratively extracts electrical power from thermoelectric section 38 generated by thermoelectric material 40, effectively serving as an additional heat sink. In one example, electric power may be directed out of thermoelectric section 38 during a cruise operational state of the engine 10.

When controller 30 determines that the natural heat transfer between cooling air system 22 and coolant system 24 is desired, controller 30 is configured to exchange no electric power with thermoelectric section 34. For example, in a ground idle operational state of engine 10, natural heat transfer from cooling air passageway 34 to coolant passageway 36 is sufficient for optimal turbine operation, and according no electric power is exchanged with thermoelectric heat exchanger 28.

When controller 30 determines that cooling air system 22 requires heat removal and/or coolant system 24 would benefit from supplemental heat, controller 30 illustratively directs current through thermoelectric section 38 in the corresponding direction to provide a determined amount of heat flow toward coolant passageway 36; for example, directing current through thermoelectric section 38 in the first direction such that additional heat is driven into coolant system 24 within coolant passageway 36 during a takeoff or climb operational state of the engine 10. Accordingly, coolant of coolant system 24 is warmed.

According to the operational state and conditions, controller 30 may determine that cooling air system 22 desires less than natural heat removal and/or coolant system 24 desires little or no supplemental heat, controller 30 directs current in the second direction to discourage heat flow from cooling air passageway 34 to coolant passageway 36. In this exemplary scenario, controller 30 illustratively determines and directs an amount of current to thermoelectric section 38 required to resist natural heat exchange from cooling air passageway 34 to coolant passageway 36, based on the turbine engine operating conditions. In one example, the controller 30 operates thermoelectric heat exchanger 28 to resist heat flow toward coolant passageway 36 by inputting electric current in the second direction during flight idle of turbine engine 10 when compressed airflow rates are relatively low.

In the illustrative embodiment, the amount of current directed through thermoelectric section 34 has a proportional relationship to the magnitude of the influence that thermoelectric section 34 exerts on heat flow between lubrication system 22 and fuel system 24. A greater amount of current directed through thermoelectric section 34 in a given direction (first or second) yields a greater influence (encouragement or discouragement) on the heat flow between systems 22, 24. A lesser amount of current directed through thermoelectric section 34 in a given direction (first or second) yields a lesser influence on heat flow between systems 22, 24. However, this proportional relationship is not necessarily linear or the same in both directions of electric current.

Referring to Figs. 2 and 3, controller 30 can operate thermoelectric heat exchanger 28 to extract electric power from thermoelectric section 38 to load 50. In the illustrative embodiment, controller 30 includes electrical circuitry 52 (as shown in Fig. 3) configured for connection of thermoelectric section 38 to load 50 in selective arrangement to either provide or extract electric power from thermoelectric section 38. Electrical circuitry 52 illustratively includes various electrical hardware components configured to selectively provide and extract electrical power to load 50 as dictated by controller 30.

In some embodiments, hardware of electrical circuitry 52 may include any number and combination of active and/or passive components for selectively electrical connection of thermoelectric section 38 to load 50 to exchange power and condition the power exchanged therebetween. In the illustrative embodiment as shown in Fig. 3, electrical circuitry 52 is shown within the box of controller 30, but in some embodiments electrical circuitry 52 may be wholly or partly district from controller 30, but be in communication with and governed by controller 30. In the illustrative embodiment, electric power provided to thermoelectric section 38 is illustratively provided by the same load 50 by configuration of electrical circuitry 52, but in some embodiments electric power may be provided to and extracted from thermoelectric section 38 via different loads.

Controller 30 illustratively includes a processor 54, a memory device 56, and a transceiver 58 as shown in Figs. 1-3. Transceiver 58 illustratively communicates signals with various gas turbine engine systems and relays the information to processor 54. Processor 54 illustratively executes instructions stored on memory device 56, based on the information from transceiver 58, to determine the desired operation of thermoelectric heat exchanger 28. In some embodiments, thermoelectric system 26 may include conditioning circuitry 60 configured to condition the flow of electric power within wiring 42.

As previously mentioned, controller 30 regulates heat exchange through thermoelectric heat exchanger 28 (and therefore between lubrication and fuel systems 22, 24) according to various operating conditions of gas turbine engine 10 as suggested Fig. 1. Controller 30 determines the operational state of turbine engine 10 based on information received from various sources. In the illustrative embodiment, controller 30 is connected to sensors 52a, 52b, 52c to receive information therefrom. Sensors 52a, 52c, are respectively configured to determine and communicate the temperature of fuel system 24 and lubrication system 22. Sensor 52b is configured to determine and communicate the rotational speed of turbine engine 10.

Controller 30 is configured to determine the operational state of turbine engine 10 based on the received information. In the illustrative embodiment, controller 30 determines the operational state based at least on the rotational speed of turbine engine 10. In some embodiments, controller 30 may determine operational state based on any of turbine engine rotational speed, acceleration (such as engine rotation and/or vehicle movement), position (such as altitude), adapted system control conditions (such as flight controls position), and/or combinations thereof, and may do so based on one or more of past, present, and/or predicted conditions thereof. In some embodiments, operating conditions and operational states may be determined by any direct and/or indirect manner suitable for such control.

Process steps 60-74 of the process flow diagram of Fig. 4 illustrate operation of thermoelectric system 26 based on operating conditions. In step 60, controller 30 determines the temperature of cooling air system 22. In step 62, controller 30 determines the temperature of coolant system 24. In step 64, controller 30 determines the operational state of turbine engine 10.

In step 66, controller 30 determines whether an excess thermal differential exists. In the illustrative embodiment, excess thermal differential exists if the temperature difference between cooling air system 22 and coolant system 24 exceeds a predetermined threshold for a given operational state of turbine engine 10. The predetermined threshold illustratively varies based on the operational state of turbine engine 10. In some embodiments, the predetermined threshold may vary based on any number of turbine engine operating conditions, for example, the absolute temperatures of cooling air system 22 and coolant system 24. In some embodiments, excess thermal differential and/or predetermined thresholds may be determined by algorithm, lookup chart, and/or any other suitable manner.

If controller 30 determines in step 66 that excess thermal differential exists, the process proceeds to step 72 as shown in Fig. 5. In step 72, controller 30 extracts electric power from thermoelectric section 38 to load 50. In the illustrative embodiment, extracting electric power includes configuration of hardware of electrical circuitry 48, as described above, to electrically connect load 50 to thermoelectric section 38 for extraction. Load 50 is illustratively embodied as a power storage device (e.g., battery) of turbine engine 10, but in some embodiments may include one more of any other electric power demands.

If controller 30 determines in step 66 that excess thermal differential does not exist, the process proceeds to step 68 as shown in Fig. 5. In step 68, controller 30 determines the amount (current) and configuration (voltage and direction) of electric power desired to be directed to thermoelectric section 38 according to the operating conditions. The amount and configuration of electric power required in step 68 is illustratively embodied as the amount and configuration of electric power to be directed through thermoelectric section 38 to produce the desired rate of heat flow across between systems 22, 24 based on the operational state and the operating conditions of turbine engine 10 as discussed above. In the illustrative embodiment, the amount and configuration of electric power is illustratively determined by algorithm, but in some embodiments may include one or more of lookup charts and/or any other suitable manner.

In step 70, controller 30 provides the determined amount and configuration of electric power to thermoelectric section 38, via configuration of hardware of electrical circuitry 52 as described above. In step 74, controller 30 monitors the operational state and operating parameters of turbine engine 10 for threshold changes. If no threshold change is determined, the parameters of the previous step (either 70 or 72) are maintained. If a threshold change is determined, the process returns to the start. In the illustrative embodiment, thresholds changes include changes in turbine engine operational states and exceedance of temperature thresholds of systems 22, 24, but in some embodiments may include any number and/or suitable considerations for re-evaluation of heat exchange within thermoelectric system 26.

The table of Fig. 5 illustrates exemplary operational states of the gas turbine engine 10 adapted for use in aircraft propulsion and their general correspondence to operation of thermoelectric system 26. The table of Fig. 5 is described according to illustrative embodiments of cooling system 24, embodied as either of an air stream and fuel system of engine 10. Operation of thermoelectric system 26 includes any of the preceding descriptions and is not limited by the exemplary correspondence presented with respect to Fig. 6.

In a ground idle state as suggested Fig. 5, thermoelectric system 26 is illustratively configured to have no electric power exchange with thermoelectric section 38 to permit natural heat transfer between systems 22, 24.

In takeoff and cruise states, thermoelectric system 26 is illustratively configured to provide power into thermoelectric section 38 in a Mode A that corresponds to heat flow from cooling air system 22 to coolant system 24. The amount and configuration of electric power provided to thermoelectric section 34 in Mode A illustratively has the same direction of current for both takeoff and cruise states, but can vary in amperage and voltage according to the operational state. In some embodiments, Mode A may include providing electric current in the second direction to reduce heat transfer from cooling air system 22 to coolant 24 below the natural heat transfer state, while still permitting heat exchange therethrough.

In a cruise state as suggested in Fig. 5, thermoelectric system 26 is illustratively configured to extract power from thermoelectric section 38 to load 44.

In a flight idle state as suggested in Fig. 5, thermoelectric system 26 is illustratively configured to provide electric power into thermoelectric section 38 in a Mode B that corresponds to thermoelectric material 35 encouraging heat flow from coolant system 24 to cooling air system 22. For example, in illustrative embodiments in which coolant system 24 is a fuel system of the engine 10, when fuel system 24 has a high temperature it may be advantageous to cool the fuel system 24 by rejecting some heat into the cooling air system 22. Such operational descriptions discussed herein are exemplary in nature and are not intended to limit the scope of operation of engine 10.

In some embodiments, coolant system 22 is embodied as a fuel system of engine 10 and may include pumps, piping, valves and accessories for circulating and delivering fuel. In the illustrative embodiment, air streams are transported through appropriate ducting and may include any dampers, blowers, and/or other accessories as required.

The present disclosure includes devices and methods which can reduce electric power demand from generators of vehicle systems, can reduce cost and weight of systems, and improve thermodynamic performance. The present disclosure includes devices and methods for allowing heat exchange between systems of similar temperatures.

While the disclosure has been illustrated and described in detail in the foregoing drawings and description, the same is to be considered as exemplary and not restrictive in character, it being understood that only illustrative embodiments thereof have been shown and described.

## Claims

1. A gas turbine engine (10) comprising
a cooling air system (22) adapted to provide cooling air to portions of the gas turbine engine (10),
a coolant system (24) adapted to provide coolant for heat exchange with the cooling air system (22) of the gas turbine engine (10), and
a thermoelectric heat exchanger (28) including a cooling air passageway (34) fluidly coupled to the cooling air system (22) to conduct cooling air of the cooling air system (22) therethrough, a coolant passageway (36) fluidly coupled to the coolant system (24) to conduct coolant of the coolant system (24) therethrough, and a thermoelectric section (38) configured in thermal communication with each of the cooling air passageway (34) and the coolant passageway (36),
**characterised in that** it further comprises a controller (30) configured to determine an operational state of the gas turbine engine (10) and to selectively apply voltage across the thermoelectric section (38) based on the operational state of the gas turbine engine (10).

2. The gas turbine engine (10) of claim 1, wherein the coolant system (24) comprises one of a coolant air system having air as the coolant and a fuel system having fuel as the coolant.

3. The gas turbine engine (10) of claim 1, wherein the gas turbine engine (10) is configured to provide propulsion for an aircraft and the operational state of the gas turbine engine (10) includes one of ground idle, takeoff, climb, cruise, and flight idle.

4. The gas turbine engine (10) of claim 3, wherein the controller (30) is configured to extract electric power from the thermoelectric section (38) in response to determination that the operational state of the gas turbine engine (10) is cruise.

5. The gas turbine engine (10) of claim 3 or 4, wherein the controller (30) is configured to apply voltage across the thermoelectric section (38) to direct current through the thermoelectric section (38) in a first direction in response to determination that the operational state of the gas turbine engine (10) is one of takeoff and climb to encourage heat transfer through the thermoelectric section (38) from the cooling air passageway (34) to the coolant passageway (36).

6. The gas turbine engine (10) of any of claims 3 to 5, wherein the thermoelectric controller (30) is configured to apply voltage across the thermoelectric section (38) to direct current through the thermoelectric section (38) in a second direction in response to determination that the operational state of the gas turbine engine (10) is flight idle.

7. The gas turbine engine (10) of any preceding claim, wherein the thermoelectric section (38) includes a number of electrically connected thermoelectric layers and the cooling air passageway (34) includes a number of cooling air conduits each having at least one wall in thermal communication with at least one of the thermoelectric layers.

8. The gas turbine engine (10) of claim 7, wherein at least one of the number of cooling air conduits has a circumferential width that is tapered along a radial direction.

9. The gas turbine engine (10) of any preceding claim, wherein the thermoelectric section (38) includes a number of electrically connected thermoelectric layers and the coolant passageway (36) includes a number of coolant conduits each having at least one wall in thermal communication with at least one of the thermoelectric layers and each of the coolant conduits defines a coolant flow path that extends radially in communication with a turnaround passage of the coolant passageway (36).

10. The gas turbine engine (10) of any preceding claim, comprising
a compressor (14) configured to pressurized air,
a combustor (16) configured to receive pressurized air from the compressor (14) and fuel for combustion (16) to yield combustion products,
a turbine (18) configured to receive and expand combustion products from the combustor (16) to drive rotation around a central axis (25), and
wherein the cooling air passageway (34) is fluidly coupled to the compressor (14) to receive pressurized air through the cooling air passageway (34).

11. The gas turbine engine (10) of any of claims 1 to 9, wherein the controller (30) is configured to selectively provide electric power generated by the thermoelectric section (38) to a load (50) of the gas turbine engine (10).

12. The gas turbine engine (10) of any of claims 3 to 11, wherein the thermoelectric heat exchanger (28) is configured to provide no electric power to the thermoelectric section (38) in response to determination that the operational state of the gas turbine engine (10) is ground idle.

13. A method of operating a gas turbine engine (10) according to claim 1 for providing propulsion for an aircraft, the method comprising
determining an operational state of the gas turbine engine (10);
based on the determined operational state, determining whether excess thermal differential exists between a cooling air system (22) and a coolant system (24) of the gas turbine engine (10);
based on the determined operational state, selectively:
applying voltage across a thermoelectric section (38) of a thermoelectric heat exchanger (28) of the gas turbine engine (10) in response to determination that excess thermal differential does not exist, or
extracting electric power from the thermoelectric section (38) of the thermoelectric heat exchanger (28) in response to determination that excess thermal differential does exist.

14. The method of claim 13, wherein selectively applying voltage across the thermoelectric section (38) of the thermoelectric heat exchanger (28) includes, in response to determination that an excess thermal differential does not exist based on the determined operational state, selectively directing current through the thermoelectric section (38) in a first direction to encourage heat transfer through the thermoelectric section (38) from the cooling air system (22) to the coolant system (24) based on the determined operational state.

15. The method of claim 13, wherein selectively applying voltage across the thermoelectric section (38) of the thermoelectric heat exchanger (28) includes, in response to determination that an excess thermal differential does not exist based on the determined operational state, selectively directing current through the thermoelectric section (38) in a second direction.

## Patentansprüche

1. Gasturbinentriebwerk (10), umfassend
ein Kühlluftsystem (22), das dazu eingerichtet ist, Teilen des Gasturbinentriebwerks (10) Kühlluft bereitzustellen,
ein Kühlmittelsystem (24), das dazu eingerichtet ist, Kühlmittel zum Wärmeaustausch mit dem Kühlluftsystem (22) des Gasturbinentriebwerks (10) bereitzustellen, und
einen thermoelektrischen Wärmeaustauscher (28) umfassend einen Kühlluftdurchgang (34), der fluidmäßig mit dem Kühlluftsystem (22) dazu verbunden ist, Kühlluft des Kühlluftsystems (22) dadurch zu leiten, einen Kühlmitteldurchgang (36), der fluidmäßig mit dem Kühlmittelsystem (24) dazu verbunden ist, Kühlmittel des Kühlmittelsystems (24) dadurch zu leiten, und einen thermoelektrischen Abschnitt (38), der in thermischer Verbindung mit jedem des Kühlluftdurchgangs (34) und des Kühlmitteldurchgangs (36) konfiguriert ist,
**dadurch gekennzeichnet, dass** es ferner eine Steuerung (30) umfasst, die dazu konfiguriert ist, einen Betriebszustand des Gasturbinentriebwerks (10) zu ermitteln und selektiv Spannung an den thermoelektrischen Abschnitt (38) basierend auf dem Betriebszustand des Gasturbinentriebwerks (10) anzulegen.

2. Gasturbinentriebwerk (10) nach Anspruch 1, wobei das Kühlmittelsystem (24) einen von einem Kühlluftsystem aufweisend Luft als das Kühlmittel und einem Kraftstoffsystem aufweisend Kraftstoff als das Kühlmittel umfasst.

3. Gasturbinentriebwerk (10) nach Anspruch 1, wobei das Gasturbinentriebwerk (10) dazu konfiguriert ist, Antrieb für ein Luftfahrzeug bereitzustellen, und der Betriebszustand des Gasturbinentriebwerks (10) einen von Bodenleerlauf, Starten, Steigen, Mit-Reisegeschwindigkeit-Fliegen, und Flugleerlauf umfasst.

4. Gasturbinentriebwerk (10) nach Anspruch 3, wobei die Steuerung (30) dazu konfiguriert ist, Elektroenergie aus dem thermoelektrischen Abschnitt (38) als Reaktion auf die Ermittlung, dass der Betriebszustand des Gasturbinentriebwerks (10) Mit-Reisegeschwindigkeit-Fliegen ist, zu entnehmen.

5. Gasturbinentriebwerk (10) nach Anspruch 3 oder 4, wobei die Steuerung (30) dazu konfiguriert ist, Spannung an den thermoelektrischen Abschnitt (38) anzulegen, um Strom durch den thermoelektrischen Abschnitt (38) in einer ersten Richtung als Reaktion auf die Ermittlung, dass der Betriebszustand des Gasturbinentriebwerks (10) eines von Starten und Steigen ist, zu leiten, um eine Wärmeübertragung durch den thermoelektrischen Abschnitt (38) vom Kühlluftdurchgang (34) zum Kühlmitteldurchgang (36) zu fördern.

6. Gasturbinentriebwerk (10) nach einem der Ansprüche 3 bis 5, wobei die thermoelektrische Steuerung (30) dazu konfiguriert ist, Spannung an den thermoelektrischen Abschnitt (38) anzulegen, um Strom durch den thermoelektrischen Abschnitt (38) in einer zweiten Richtung als Reaktion auf die Ermittlung, dass der Betriebszustand des Gasturbinentriebwerks (10) Flugleerlauf ist, zu leiten.

7. Gasturbinentriebwerk (10) nach einem der vorhergehenden Ansprüche, wobei der thermoelektrische Abschnitt (38) eine Anzahl von elektrisch verbundenen thermoelektrischen Schichten umfasst und der Kühlluftdurchgang (34) eine Anzahl von Kühlluftkanälen umfasst, die jeweils mindestens eine Wand in thermischer Verbindung mit mindestens einer von den thermoelektrischen Schichten aufweisen.

8. Gasturbinentriebwerk (10) nach Anspruch 7, wobei mindestens einer der Anzahl von Kühlluftkanälen eine Umfangsbreite aufweist, die entlang einer radialen Richtung verjüngt ist.

9. Gasturbinentriebwerk (10) nach einem der vorhergehenden Ansprüche, wobei der thermoelektrische Abschnitt (38) eine Anzahl von elektrisch verbundenen thermoelektrischen Schichten umfasst und der Kühlmitteldurchgang (36) eine Anzahl von Kühlmittelleitungen umfasst, die jeweils mindestens eine Wand in thermischer Verbindung mit mindestens einer von den thermoelektrischen Schichten aufweisen, und jede der Kühlmittelleitungen einen Kühlmitteldurchflussweg definiert, der sich radial in Verbindung mit einem Wendedurchgang des Kühlmitteldurchgangs (36) erstreckt.

10. Gasturbinentriebwerk (10) nach einem der vorhergehenden Ansprüche, umfassend einen Kompressor (14), der dazu konfiguriert ist, Luft unter Druck zu setzen,
eine Brennkammer (16), die dazu konfiguriert ist, unter Druck stehende Luft aus dem Kompressor (14) und Kraftstoff zur Verbrennung (16) aufzunehmen, um Verbrennungsprodukte zu liefern, eine Turbine (18), die dazu konfiguriert ist, Verbrennungsprodukte aus der Brennkammer (16) aufzunehmen und zu expandieren, um eine Rotation um eine Mittelachse (25) herum anzutreiben, und
wobei der Kühlluftdurchgang (34) fluidmäßig mit dem Kompressor (14) verbunden ist, um unter Druck stehende Luft durch den Kühlluftdurchgang (34) aufzunehmen.

11. Gasturbinentriebwerk (10) nach einem der Ansprüche 1 bis 9, wobei die Steuerung (30) dazu konfiguriert ist, einer Last (50) des Gasturbinentriebwerks (10) selektiv Elektroenergie bereitzustellen, die durch den thermoelektrischen Abschnitt (38) erzeugt wird.

12. Gasturbinentriebwerk (10) nach einem der Ansprüche 3 bis 11, wobei der thermoelektrische Wärmeaustauscher (28) dazu konfiguriert ist, dem thermoelektrischen Abschnitt (38) als Reaktion auf die Ermittlung, dass der Betriebszustand des Gasturbinentriebwerks (10) Bodenleerlauf ist, keine Elektroenergie bereitzustellen.

13. Verfahren zum Betreiben eines Gasturbinentriebwerks (10) nach Anspruch 1 zum Bereitstellen von Antrieb für ein Luftfahrzeug, wobei das Verfahren Folgendes umfasst:
Ermitteln eines Betriebszustands des Gasturbinentriebwerks (10);
basierend auf dem ermittelten Betriebszustand, Ermitteln, ob eine überschüssige thermische Differenz zwischen einem Kühlluftsystem (22) und einem Kühlmittelsystem (24) des Gasturbinentriebwerks (10) vorhanden ist;
basierend auf dem ermittelten Betriebszustand, selektiv:
Anlegen von Spannung an einen thermoelektrischen Abschnitt (38) eines thermoelektrischen Wärmeaustauschers (28) des Gasturbinentriebwerks (10) als Reaktion auf das Ermitteln, dass keine überschüssige thermische Differenz vorhanden ist, oder
Entnehmen von elektrischer Energie von dem thermoelektrischen Abschnitt (38) des thermoelektrischen Wärmeaustauschers (28) als Reaktion auf das Ermitteln, dass keine überschüssige thermische Differenz vorhanden ist.

14. Verfahren nach Anspruch 13, wobei das selektive Anlegen von Spannung an den thermoelektrischen Abschnitt (38) des thermoelektrischen Wärmeaustauschers (28), als Reaktion auf das Ermitteln, dass keine überschüssige thermische Differenz basierend auf dem ermittelten Betriebszustand vorhanden ist, das selektive Leiten von Strom durch den thermoelektrischen Abschnitt (38) in einer ersten Richtung umfasst, um eine Wärmeübertragung durch den thermoelektrischen Abschnitt (38) vom Kühlluftsystem (22) zum Kühlmittelsystem (24) basierend auf dem ermittelten Betriebszustand zu fördern.

15. Verfahren nach Anspruch 13, wobei das selektive Anlegen von Spannung an den thermoelektrischen Abschnitt (38) des thermoelektrischen Wärmeaustauschers (28), als Reaktion auf das Ermitteln, dass keine überschüssige thermische Differenz basierend auf dem ermittelten Betriebszustand vorhanden ist, das selektive Leiten von Strom durch den thermoelektrischen Abschnitt (38) in einer zweiten Richtung umfasst.

## Revendications

1. Moteur à turbine à gaz (10) comprenant un système d'air de refroidissement (22) adapté pour fournir de l'air de refroidissement à des parties du moteur à turbine à gaz (10), un système de fluide de refroidissement (24) adapté pour fournir un fluide de refroidissement pour un échange de chaleur avec le système d'air de refroidissement (22) du moteur à turbine à gaz (10) et un échangeur de chaleur thermoélectrique (28) comprenant un passage d'air de refroidissement (34) couplé de façon fluidique au système d'air de refroidissement (22) pour mener l'air de refroidissement du système d'air de refroidissement (22) à travers celui-ci, un passage de fluide de refroidissement (36) couplé de façon fluidique au système de refroidissement (24) pour mener le fluide de refroidissement du système de refroidissement (24) à travers celui-ci, et une section thermoélectrique (38) conçue pour être en communication thermique avec chacun des passages d'air de refroidissement (34) et le passage de fluide de refroidissement (36), **caractérisé en ce qu'**il comprend en outre un dispositif de commande (30) conçu pour déterminer un état de fonctionnement du moteur à turbine à gaz (10) et pour appliquer sélectivement une tension aux bornes de la section thermoélectrique (38) sur la base de l'état de fonctionnement du moteur à turbine à gaz (10).

2. Moteur à turbine à gaz (10) selon la revendication 1, ledit système de fluide de refroidissement (24) comprenant l'un d'un système d'air de refroidissement possédant l'air en tant que fluide de refroidissement et un système de combustible possédant un combustible en tant que fluide de refroidissement.

3. Moteur à turbine à gaz (10) selon la revendication 1, ledit moteur à turbine à gaz (10) étant conçu pour assurer la propulsion d'un aéronef et ledit état de fonctionnement du moteur à turbine à gaz (10) comprenant l'un d'un régime de ralenti au sol, d'un régime de décollage, d'un régime de montée, d'un régime de croisière et d'un régime de ralenti en vol.

4. Moteur à turbine à gaz (10) selon la revendication 3, ledit dispositif de commande (30) étant conçu pour extraire de l'énergie électrique de la section thermoélectrique (38) en réponse à la détermination que l'état de fonctionnement du moteur à turbine à gaz (10) est en régime de croisière.

5. Moteur à turbine à gaz (10) selon la revendication 3 ou 4, ledit dispositif de commande (30) étant conçu pour appliquer une tension aux bornes de la section thermoélectrique (38) pour diriger le courant à travers la section thermoélectrique (38) dans un premier sens en réponse à la détermination que l'état de fonctionnement du moteur à turbine à gaz (10) est l'un d'un régime de décollage et d'un régime de montée pour favoriser le transfert de chaleur à travers la section thermoélectrique (38) du passage d'air de refroidissement (34) au passage de fluide de refroidissement (36).

6. Moteur à turbine à gaz (10) selon l'une quelconque des revendications 3 à 5, ledit dispositif de commande thermoélectrique (30) étant conçu pour appliquer une tension aux bornes de la section thermoélectrique (38) pour diriger le courant à travers la section thermoélectrique (38) dans un second sens en réponse à la détermination que l'état de fonctionnement du moteur à turbine à gaz (10) est en régime de ralenti en vol.

7. Moteur à turbine à gaz (10) selon l'une quelconque des revendications précédentes, ladite section thermoélectrique (38) comprenant un nombre de couches thermoélectriques connectées électriquement et ledit passage d'air de refroidissement (34) comprenant un nombre de conduits d'air de refroidissement, possédant chacun au moins une paroi en communication thermique avec au moins l'une des couches thermoélectriques.

8. Moteur à turbine à gaz (10) selon la revendication 7, au moins l'un du nombre de conduits d'air de refroidissement possédant une largeur circonférentielle qui est effilée le long d'une direction radiale.

9. Moteur à turbine à gaz (10) selon l'une quelconque des revendications précédentes, ladite section thermoélectrique (38) comprenant un nombre de couches thermoélectriques connectées électriquement et le passage de fluide de refroidissement (36) comprenant un nombre de conduits de fluide de refroidissement possédant chacun au moins une paroi en communication thermique avec au moins l'une des couches thermoélectriques et chacun des conduits de fluide de refroidissement définissent un trajet d'écoulement de fluide de refroidissement qui s'étend radialement en communication avec un passage de retournement du passage de fluide de refroidissement (36).

10. Moteur à turbine à gaz (10) selon l'une quelconque des revendications précédentes, comprenant un compresseur (14) conçu pour accroître la pression de l'air, une chambre de combustion (16) conçue pour recevoir l'air sous pression provenant du compresseur (14) et du combustible destiné à la combustion (16) pour produire des produits de combustion,
une turbine (18) conçue pour recevoir et dilater les produits de combustion provenant de la chambre de combustion (16) pour entraîner la rotation autour d'un axe central (25) et ledit passage d'air de refroidissement (34) étant couplé de façon fluidique au compresseur (14) pour recevoir l'air sous pression à travers le passage d'air de refroidissement (34).

11. Moteur à turbine à gaz (10) selon l'une quelconque des revendications 1 à 9, ledit dispositif de commande (30) étant conçu pour fournir sélectivement de l'énergie électrique générée par la section thermoélectrique (38) à une charge (50) du moteur à turbine à gaz (10).

12. Moteur à turbine à gaz (10) selon l'une quelconque des revendications 3 à 11, ledit échangeur de chaleur thermoélectrique (28) étant conçu pour ne pas fournir d'énergie électrique à la section thermoélectrique (38) en réponse à la détermination que l'état de fonctionnement du moteur à turbine à gaz (10) est en régime de ralenti au sol.

13. Procédé de fonctionnement d'un moteur à turbine à gaz (10) selon la revendication 1 permettant la fourniture d'une propulsion à un aéronef, ledit procédé comprenant la détermination d'un état de fonctionnement du moteur à turbine à gaz (10) ; sur la base de l'état de fonctionnement déterminé, la détermination pour savoir si un différentiel thermique excessif existe entre un système d'air de refroidissement (22) et un système de fluide de refroidissement (24) du moteur à turbine à gaz (10) ;
sur la base de l'état de fonctionnement déterminé, de manière sélective :
l'application d'une tension aux bornes d'une section thermoélectrique (38) d'un échangeur de chaleur thermoélectrique (28) du moteur à turbine à gaz (10) en réponse à la détermination qu'un différentiel thermique en excès n'existe pas, ou l'extraction de l'énergie électrique de la section thermoélectrique (38) de l'échangeur de chaleur thermoélectrique (28) en réponse à la détermination qu'un différentiel thermique excessif existe.

14. Procédé selon la revendication 13, ladite application de manière sélective d'une tension aux bornes de la section thermoélectrique (38) de l'échangeur de chaleur thermoélectrique (28) comprenant, en réponse à la détermination qu'un différentiel thermique excessif n'existe pas sur la base de l'état de fonctionnement déterminé, la direction de manière sélective du courant à travers la section thermoélectrique (38) dans un premier sens pour favoriser le transfert de chaleur à travers la section thermoélectrique (38) du système d'air de refroidissement (22) au système de fluide de refroidissement (24) sur la base de l'état de fonctionnement déterminé.

15. Procédé selon la revendication 13, ladite application de manière sélective d'une tension aux bornes de la section thermoélectrique (38) de l'échangeur de chaleur thermoélectrique (28) comprenant, en réponse à la détermination qu'un différentiel thermique excessif n'existe pas sur la base de l'état de fonctionnement déterminé, la direction du courant de manière sélective à travers la section thermoélectrique (38) dans un second sens.
